# EUROPEAN PATENT SPECIFICATION

(11) **EP 0 749 159 B1**
(45) Date of publication and mention of the grant of the patent: **16.08.2001**
(21) Application number: 96114416.9
(22) Date of filing: 07.01.1994
(51) Int. Cl.: H01L 23/06, H01L 23/24, H01L 23/04

(54) **Resin-sealed semiconductor device**
Im Harz versiegelte Halbleitervorrichtung
Dispositif semi-conducteur scellé par une résine

(30) Priority: 13.01.1993 JP 364693; 06.05.1993 JP 10484993
(43) Date of publication of application: 18.12.1996
(62) Divisional of application: 94300096.8
(73) Proprietor: FUJI ELECTRIC CO. LTD., Kawasaki 210 (JP)
(72) Inventor: Haraguchi, Koichi, Kawasaki-ku, Kawasaki 210 (JP); Ichimura, Yuji, Kawasaki-ku, Kawasaki 210 (JP)
(74) Representative: Bridge-Butler, Alan James

(56) References cited:
- GB-A- 2 264 389
- PATENT ABSTRACTS OF JAPAN vol. 016, no. 539 (E-1289), 10 November 1992 & JP 04 206554 A (HITACHI LTD;OTHERS: 01), 28 July 1992,
- DATABASE WPI Section Ch, Week 9235 Derwent Publications Ltd., London, GB; Class A26, AN 92-289003 XP002021127 & JP 04 198 267 A (DAINIPPON INK & CHEM KK) , 17 July 1992
- DATABASE WPI Section Ch, Week 8842 Derwent Publications Ltd., London, GB; Class A85, AN 88-297553 XP002021128 & JP 63 219 145 A (SUMITOMO BAKELITE KK) , 12 September 1988
- DATABASE WPI Section Ch, Week 8842 Derwent Publications Ltd., London, GB; Class A26, AN 88-297555 XP002021129 & JP 63 219 147 A (SUMITOMO BAKELITE KK) , 12 September 1988
- DATABASE WPI Section Ch, Week 9211 Derwent Publications Ltd., London, GB; Class A26, AN 92-085329 XP002021130 & JP 04 028 764 A (SUMITOMO BAKELITE KK) , 31 January 1992

## Description

This invention relates to a resin-sealed semiconductor device, and particularly relates to a resin-sealed transistor module.

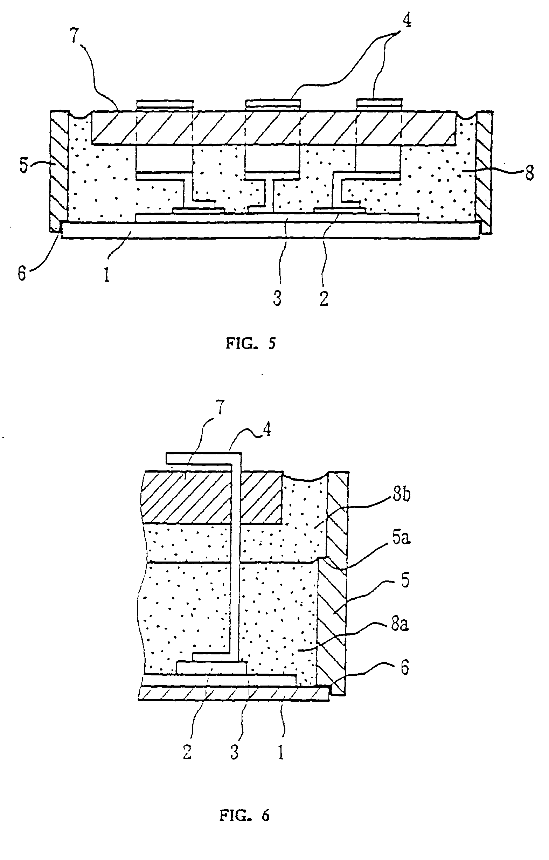

Figure 5 shows a conventional resin-sealed semiconductor device. In this diagram, reference number 1 designates a metallic base plate that also serves as a heat radiation plate, reference number 2 a semiconductor element that is mounted on metallic base plate 1 via substrate 3, reference number 4 a lead-out terminal soldered to the surface electrode of semiconductor element 2 or to the conductor pattern of substrate 3 and drawn out upwardly. Reference number 5 indicates a moulded resin covering case bonded with adhesive 6 to the peripheral edge of the metallic base plate 1, and a moulded resin terminal-supporting plate 7 serves as the case lid on the upper surface of covering case 5. A sealing resin 8 fills the inside of covering case 5. In addition, there are also two different types of sealing resin 8: one is made entirely of epoxy resin, and the other is divided into two layers (upper and lower), wherein the lower layer is made of silicon gel and the upper layer is made of epoxy resin. In the two-layered (upper and lower) sealing resin 8, as the cross-sectional view of Figure 6 shows, a step 5a is usually formed on the inner surface of covering case 5, and filling the inside of covering case 5 with silicon gel 8a stops before the level of silicon gel 8a reaches the step 5a. The remaining portion is filled with epoxy resin 8b to harden the inside of covering case 5. A device of this type is known from JP-A-4206554.

Although the type of resin material for covering case 5 and terminal-supporting plate 7 are selected in consideration of their resistance to heat, flameproofing property, colouring property, electrical characteristics, and moulding costs, usually PBT (polybutylene terephthalate) resin or PPS (polyphenylene sulphide) resin is used for covering case 5 and PPS resin for terminal-supporting plate 7.

According to the configuration of said conventional resin-sealed semiconductor device, peeling occurs in between the components during actual use or in temperature cycle tests by mutual adhesive failure. This peeling further causes problems such as degrading of moisture resistance performance of the device and leaking of the sealing resin (gelatinoid filler) from the covering case. In particular, the adherent surface between the covering case and the sealing resin, and the adherent surface between the terminal-supporting plate and the sealing resin easily separate. Epoxy resin is used as the sealing resin and solidified at about 135°C. The transition temperature required to solidify epoxy resin into glass is 140 - 160°C, and at temperatures below that range the elasticity of the hardened epoxy resin is highly stable at approximately 1,200 kg/mm². The glass transition temperature for PPS resin is 80 - 90°C, and although at temperatures below this range the elasticity of PPS resin is very stable at approximately about 1,800 kg/mm², at temperatures above this range the elasticity of the PPS resin tends gradually to decrease. Accordingly, for a covering case and terminal-supporting plate made of PPS resin, in order to fill the inside of the covering case and solidify the PPS resin at about 135°C, since the elasticity of the PPS resin, which decreases somewhat, does not change considerably, a difference in the elasticity of the PPS resin and the epoxy resins arises, causing further latent stress in the adherent surface between the covering case and the sealing resin, and between the terminal-supporting plate and the sealing resin. Since an external mechanical stress such as high tension or bending load is likely to be applied to said adherent surfaces during connection of the external wiring to lead-out terminals, peeling can occur not only between the terminal-supporting plate which supports the lead-out terminals and the sealing resin, but also between the covering case and the sealing resin. When the lead-out terminal comes loose due to the peeling thus caused, stress is also applied to the soldered sections between the lead-out terminals and the semiconductor device, thereby causing serious defects such as damage to the semiconductor device.

Furthermore, when an attempt is made to use an adhesive to solidify the adhesive used to bond the metallic base plate to the external covering case, the adhesive runs out of the adherent section and then under the lower surface of the metallic base plate and adheres thereto, thereby damaging the smoothness of the mounting surface, reducing the adhesiveness of the semiconductor device to an apparatus, degrading the heat radiation performance of the semiconductor device or causing the adhesive to further run into screw holes prepared on the metallic base plate for mounting the semiconductor device, thereby preventing the mounting of the semiconductor device or loosening the screws in use.

JP-A-04 198 267 proposes the use of resin compositions comprising a mixture of polyarylene sulphide resins and carboxyl containing polyarylene sulphide resins for moulding electronic parts as the mixture has improved adhesive properties.

The object of the present invention is to provide stiff and highly reliable resin-sealed semiconductor devices by resolving said problems and by preventing the adhesive between structural components from losing its adhesive properties.

According to the invention there is provided a resin-sealed semiconductor device wherein the terminal-supporting plate or the covering case consists of a polyphenylene sulphide (PPS) resin, characterised in that an epoxy group, 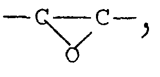 is substituted on either the chain or terminal phenylene groups in the polyphenylene sulphide chains of the resin.

Accordingly, the sealing resin and either the terminal-supporting plate or the covering case can deal flexibly with the stress imposed by the sealing resin in the hardening process, thereby preventing the terminal-supporting plate from peeling off from the covering case when an external force is applied to the terminal-supporting plate.

An exemplary embodiment of this invention is explained below with reference to the attached drawings, in which:
Figure 1 shows a first embodiment of the present device, wherein Figure 1a is a sectional view, and Figure 1b is a partial external view of the terminal-supporting plate shown in Figure 1a;
Figure 2 is a sectional view showing a second embodiment of the device of this invention;
Figure 3 is a sectional view showing a third embodiment of the present device;
Figure 4 is a sectional view showing a fourth embodiment of the present device;
Figure 5 is a sectional view of a conventional resin-sealed semiconductor device;
Figure 6 is a sectional view of a second conventional resin-sealed semiconductor device; and
Figure 7 is a diagram showing the molecular structure of PPS resin, wherein Figure 7a shows the structure of an ordinary PPS polymer, wherein Figure 7b shows the structure of the PPS polymer related to this invention.

In the drawings, components which correspond to components shown in Figures 5 and 6 are designated by the same reference numbers.

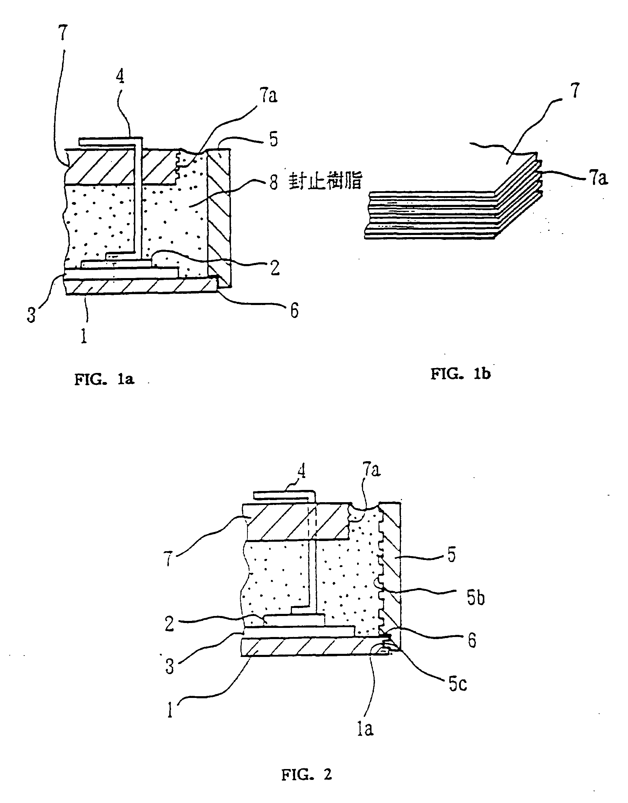

Figure 1 shows an example of this invention, Figure 1 a being a sectional view, and Figure 1 b a partial external view of the terminal-supporting plate shown in Figure 1a. Figure 1 shows peripheral ridges 7a moulded on the outer peripheral edge surface of terminal-supporting plate 7, through which lead-out terminal 4 passes. The peripheral edge surface of the terminal-supporting plate 7 is thus roughened. These ridges 7a are produced either by being moulded together with the terminal-supporting plate or by grooving or slitting said plate.

In the above configuration, since sealing resin 8 with which the inside of covering case 5 has been filled has run between the ridges 7a and hardened, the increase in the adhesive area and the anchoring effect by ridges 7a results in a high adhesive strength between terminal-supporting plate 7 and sealing resin 8. Accordingly, even when a large external force (e.g., tension or bending load) is applied to lead-out terminal 4 during actual operation, the bonding surface is no longer likely to peel off easily from terminal-supporting plate 7 or sealing resin 8.

Figure 2 is a sectional view of a further development of the embodiment seen in Figure 1, in which irregular ridges 7a are moulded onto the outer peripheral surface of terminal-supporting plate 7 to roughen that surface, and a number of ridges 5b are moulded onto the inner surface of the wall of covering case 5 to roughen the inner surface of the wall. Onto the adherent surface provided for adhesive 6 between metallic base plate 1 and covering case 5, uneven stepped sections 1 a and 5c are moulded. With the above configuration, both the adhesive strength between covering case 5 and sealing resin 8, and that between metallic base plate 1 and covering case 5 are enhanced, thereby increasing the adhesive strength of the entire resin-sealed semiconductor device. Roughening both the outer peripheral surface of terminal-supporting plate 7 and the inner wall of covering case 5 to obtain an uneven surface may be done using sandpaper or a cutting device of sufficient hardness compared with that of the resin to cut or scratch the outer peripheral surface of terminal-supporting plate 7 and the inner wall of covering case 5 after moulding. In this case, since the cutting or scratching that is done after terminal-supporting plate 7 and covering case 5 are moulded also removes the mould lubricant present on their surfaces, the moulding resin and the sealing resin directly touch, thereby further enhancing adhesion.

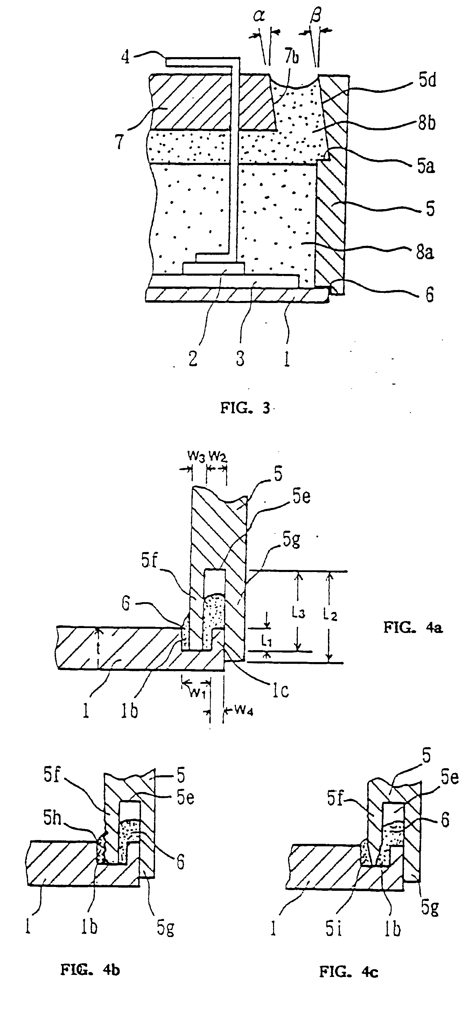

Figure 3 is a sectional view showing a further embodiment of this invention, in which the outer peripheral surface of terminal-supporting plate 7 is made to incline so as to face upwardly and the inclined surface is inclined face 7b where the angle a of the contact surface between the outer peripheral surface of terminal-supporting plate 7 and sealing resin 8 is greater than 0°, and the surface 5b of covering case 5 facing inclined face 7b is made to incline so as to face downwardly, the angle β of the contact surface between the surface 5b of covering case 5 facing inclined face 7b and sealing resin 8 is greater than 0°. Inclining the contact surface between the outer peripheral surface of terminal-supporting plate 7 and sealing resin 8 and that part of the contact surface between the surface of covering case 5 facing the former inclined surface, and sealing resin 8 will prevent terminal-supporting plate 7 from slipping when an external force is applied to lead-out terminal 4. Although such an effect can be obtained also by inclining only the outer peripheral surface of terminal-supporting plate 7, it is found that by also inclining the part of the surface of covering case 5 facing the slanting surface, the effect of protecting terminal-supporting plate 7 from slipping is improved. The above inclination can be achieved by changing the moulding die or by cutting after moulding. Furthermore, unevenly finishing these slanting surfaces is the most preferred method to obtain the aforementioned roughening effect.

Figure 4 is an enlarged sectional view showing another embodiment of this invention, in which a groove is formed in the section adhered to metallic base plate 1 and in the section adhered to covering case 5, and these grooves are fitted into each other to securely adhere these sections, and in which each of Figures 4a, 4b, and 4c shows an example of a different configuration. In Figure 4a, a groove 1b of width W₁ and depth L₁ is prepared in the peripheral section of metallic base plate 1; a groove 5e of width W₂ and depth L₂ is prepared in the end face of covering case 5, and 1 c indicates an outer wall bounding groove 1 b. The reference numbers 5f and 5g indicate the inner wall and outer wall, respectively, of groove 5e. In terms of physical dimensions, the relationships between height L₃ and width W₃ of inner wall 5f of groove 5e, and depth L₁ and width W₁ of groove 1 b are such that L₃ > L₁, and W₃ < W₁, respectively. Furthermore, the relationship between the height of outer wall 5g of groove 5e (i.e. depth L₂ of groove 5e) and L₃ is that: L₂ > L₃. Therefore, if the thickness of the metallic base plate 1 is t, the relationship between L₂, L₃, t, and L₁ can be defined as: L₂ < L₃ + t - L₁, and the relationship between width W₄ of outer wall 1c of groove 1 b and width W₂ of groove 1 b is W₄ < W₂. Accordingly, when adhering metallic base plate 1 to covering case 5, the tip of inner wall 5f can be fitted into groove 1b, and outer wall 1c can be fitted into groove 5e so as to interfit grooves 1 b and 5e. Then, the tip of inner wall 5f butts against the bottom of groove 1 b to form the vertical supporting section of covering case 5, and the tip of outer wall 5g does not extend as far as the lower surface of metallic base plate 1. Furthermore, a cavity exists in the bottom section of groove 5e. When filling groove 1b with adhesive 6 and adhering metallic base plate 1 to covering case 5 with grooves 1 b and 5e interfitted with each other as stated above, they are made to adhere to each other over a wide adhesive area, and furthermore, since both grooves are interfitted with each other, metallic base plate 1 and covering case 5 will adhere strongly. In addition, since any surplus adhesive will remain in the cavity in the bottom section of groove 5e, the adhesive will not run outside the adhered section, nor for example, reach the lower surface of metallic base plate 1 to obstruct adhesion of the semiconductor device to an apparatus, and degrade the heat radiation of the device.

Figure 4b shows a configuration where outer surface 5h of inner wall 5f of groove 5e of covering case 5 is roughened to further strengthen adhesion as compared to the embodiment of Figure 4a, and Figure 4c shows a configuration where the top section of groove 5e of the covering case is formed into taper 5i so that the adhesion area can be widened to enhance the adhesive strength and also make mould lubrication easier when moulding covering case 5.

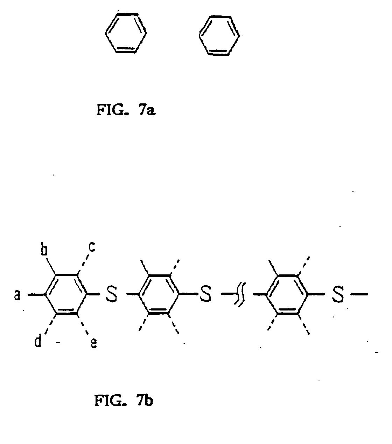

In this invention, either the terminal-supporting plate or the covering case is made of straight-chain PPS resin, moulded using PPS resin of molecular structure containing the following group: 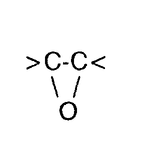 Straight-chain PPS resin is a polycondensation of dichlorobenzene 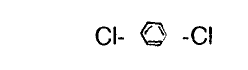 and sodium sulphide (Na-S-Na), which produces PPS with high molecular weight and which cleans the PPS with high molecular weight to remove impurity product NaCI therefrom. Then, the aforementioned group is introduced or added to the addition group or terminal group of a molecular design to produce a PPS resin containing the group. Furthermore, during polycondensation, it is effective to mix the group together with an additive. It is also effective to use ordinary PPS resin to mould the terminal-supporting plate and the covering case, and then apply ultraviolet light of wavelength 185 nm or 254 nm to the contact surfaces between the terminal-supporting plate, covering case, and sealing resin, or to apply plasma thereto to generate a radical on the surface. Figure 7 is a diagram of the molecular structure of PPS, Figure 7a the molecular structure of an ordinary PPS polymer, and Figure 7b the molecular structure of the PPS resin relating to this invention, wherein the chain of the structure shown in Figure 7a is cut at the middle, and wherein a molecular structure having the following group is added to part of a and b, c, d, and e of a benzene ring:

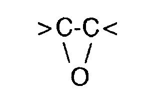

As mentioned above, by forming straight-chain PPS that contains the group, not only can the heat resistance (260°C), flame resistance (the self-quenching property of PPS resin is industrially advantageous), and range of colours (black; green; white), which are the main characteristics of straight-chain PPS resin, be reproduced, but also an effect can be obtained that the group is connected by means of hydrogen bonding (X-H ... Y or X ... H-Y) to the same group of epoxy resin, that PPS resin and epoxy resin are bonded at a molecular level, and that adhesion of the terminal-supporting plate to the covering case becomes stronger.

Furthermore, adding fibreglass or silica (SiO₂) to the above PPS resin is preferable for enhancing the mechanical strength of the resin and the adhesion of PPS resin to epoxy resin.

Although the aforementioned has been described separately for the covering case and the terminal-supporting plate, making PPS resin that contains at least the aforementioned group is effective even for a monolithic mould of the covering case and the terminal-supporting plate.

In accordance with the characteristics mentioned above, this invention has the following effects.

By moulding either the terminal-supporting plate or the covering case with PPS resin prepared by combining a 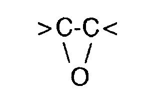 group with part of either the addition group or terminal group of a molecular design, bonding at molecular level is further added to the adhesion of the terminal-supporting plate or the covering case and sealing resin, thereby improving the strength of the adhesion.

## Claims

1. A resin-sealed semiconductor device wherein the terminal-supporting plate (7) or the covering case (5) consists of a polyphenylene sulphide (PPS) resin, characterised in that an epoxy group, 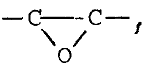 is substituted on either the chain or terminal phenylene groups in the polyphenylene sulphide chains of the resin.

## Patentansprüche

1. In Harz versiegeltes Halbleiterbauelement, wobei die Anschlußträgerplatte (7) oder das Deckgehäuse (5) aus einem Polyphenylensulfid- (PPS) Harz besteht, dadurch gekennzeichnet, daß eine Epoxidgruppe 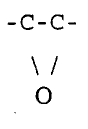 an entweder den Ketten-oder endständigen Phenylengruppen in den Polyphenylensulfid-Ketten des Harzes substituiert ist.

## Revendications

1. Un dispositif à semi-conducteur noyé dans la résine, dans lequel la plaque support terminale (7) ou le boîtier de couverture (5) consiste en une résine de poly(sulfure de phénylène) (PPS), caractérisé en ce qu'un groupe époxy, 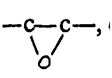 est un substituant des groupes phénylènes de la chaîne ou terminaux des chaînes poly(sulfure de phénylène) de la résine.
